# EUROPEAN PATENT SPECIFICATION

(11) **EP 2 909 868 B1**
(45) Date of publication and mention of the grant of the patent: **20.06.2018**
(21) Application number: 13848026.4
(22) Date of filing: 16.10.2013
(51) Int. Cl.: H01L 41/29, H01L 41/45, B32B 37/02

(54) **METHOD OF METALLIZING DIELECTRIC FILM**
VERFAHREN ZUR METALLISIERUNG EINES DIELEKTRISCHEN FILMS
PROCÉDÉ PERMETTANT DE MÉTALLISER UN FILM DIÉLECTRIQUE

(30) Priority: 16.10.2012 US 201261714306 P
(43) Date of publication of application: 26.08.2015
(73) Proprietor: Parker-Hannifin Corporation, Cleveland, OH 44124 (US)
(72) Inventor: QUAN, Xina, Saratoga, CA 95070 (US); NGUYEN, Hong, An, San Jose, CA 95121 (US); LEONG, Weyland, San Francisco, CA 94134 (US)
(74) Representative: Murgitroyd & Company
(86) International application number: PCT/US2013/065195
(87) International publication number: WO 2014/062776

(56) References cited:
- WO-A1-2012/032437
- WO-A1-2012/044419
- WO-A2-2008/039658
- US-A1- 2006 188 697
- US-A1- 2008 180 875
- US-A1- 2009 072 658
- US-A1- 2009 117 373
- US-A1- 2012 169 184
- US-B2- 7 190 016
- US-B2- 7 518 284

## Description

### FIELD OF THE INVENTION

The present invention is directed in general to metallizing dielectric films and more specifically to methods of metallizing electroactive polymers.

### BACKGROUND OF THE INVENTION

A tremendous variety of devices used today rely on actuators of one sort or another to convert electrical energy to mechanical energy. Conversely, many power generation applications operate by converting mechanical action into electrical energy, Employed to harvest mechanical energy in this fashion, the same type of device may be referred to as a generator. Likewise, when the structure is employed to convert physical stimulus such as vibration or pressure into an electrical signal for measurement purposes, it may be characterized as a sensor. Yet, the term "transducer" may be used to generically refer to any of the devices.

A number of design considerations favor the selection and use of advanced dielectric elastomer materials, also referred to as "electroactive polymers", for the fabrication of transducers. These considerations include potential force, power density, power conversion/consumption, size, weight, cost, response time, duty cycle, service requirements, environmental impact, etc. As such, in many applications, electroactive polymer technology offers an ideal replacement for piezoelectric, shape-memory alloy and electromagnetic devices such as motors and solenoids.

An electroactive polymer transducer comprises two electrodes having deformable characteristics and separated by a thin elastomeric dielectric material. When a voltage difference is applied to the electrodes, the oppositely charged electrodes attract each other thereby compressing the polymer dielectric layer therebetween. As the electrodes are pulled closer together, the dielectric polymer film becomes thinner (the Z-axis component contracts) as it expands in the planar directions (along the X- and Y-axes), i.e., the displacement of the film is in-plane. The electroactive polymer film may also be configured to produce movement in a direction orthogonal to the film structure (along the Z-axis), i.e., the displacement of the film is out-of-plane. For example, U.S. Pat. No. 7,567,681 discloses electroactive polymer film constructs which provide such out-of-plane displacement - also referred to as surface deformation or as thickness mode deflection.

The material and physical properties of the electroactive polymer film may be varied and controlled to customize the deformation undergone by the transducer. More specifically, factors such as the relative elasticity between the polymer film and the electrode material, the relative thickness between the polymer film and electrode material and/or the varying thickness of the polymer film and/or electrode material, the physical pattern of the polymer film and/or electrode material (to provide localized active and inactive areas), the tension or pre-strain placed on the electroactive polymer film as a whole, and the amount of voltage applied to or capacitance induced upon the film may be controlled and varied to customize the features of the film when in an active mode.

Numerous applications exist that benefit from the advantages provided by such electroactive polymer films whether using the film alone or using it in an electroactive polymer actuator. One of the many applications involves the use of electroactive polymer transducers as actuators to produce haptic, tactile, vibrational feedback (the communication of information to a user through forces applied to the user's body), and the like, in user interface devices. There are many known user interface devices which employ such feedback, typically in response to a force initiated by the user. Examples of user interface devices that may employ such feedback include keyboards, keypads, game controller, remote control, touch screens, computer mice, trackballs, stylus sticks, joysticks, etc.

Use of electroactive polymer materials in consumer electronic media devices as well as the numerous other commercial and consumer applications highlights the need to increase production volume while maintaining precision and consistency of the films.

High conductivity electrodes are required for many polymer film applications, Stretchable and/or flexible electrodes are required for devices such as electroactive polymer transducers, thin film sensors, capacitors, and thin film batteries. For applications requiring flexibility and/or stretchability, it may be difficult to use metallic electrodes which are stiff and may crack when thin enough to be flexible. They are particularly difficult to use for applications such as electroactive polymer devices where the electrode may need to stretch several percent or more beyond the elongation possible for metal films.

Carbon-based inks may be too resistive for devices that require highly conductive electrodes such as large area electroactive polymer (EAP) actuators or generators. Corrugated electrodes have been proposed for this application, such as described in U.S. Pat. No. 7,199,501 issued to Pei et al., which discloses the use of textured or corrugated metallic electrodes to combine metallic conductivity with the extensibility required for electroactive polymer devices. Pei et al., disclose a process to create this structure by depositing a stiff conductive or nonconductive coating on a pre-stretched film and then relaxing it to form corrugations.

Benslimane et al., disclose a method in U. S. Pat. No. 7,548,284 wherein a polymer film is cast onto a release liner with a corrugated surface. The polymer film is removed from the release liner and metal film is deposited onto the corrugated surface of the polymer film.

WO/2013/049485, in the name of Biggs et al., discloses a method wherein a polymer film is only partially cured and then is thermally embossed to pattern the exposed surface with a texture. A metal film is then deposited onto the textured surface of the polymer film.

It can be difficult to deposit metal film onto the surface of elastomeric polymers, such as silicone and polyurethane polymers, which may outgas and stretch during processing. It can also be a complicated (and therefore expensive) process to create the texture on a polymer film followed by deposition of a metallic film onto the textured surface of the polymer film.

Direct embossing techniques may require high pressures and temperatures, particularly for cross-linked films. Throughput may be limited by the kinetics of bond rearrangement and re-formation. These approaches also require separate metallization and lamination steps,

U.S. Pat. No. 5,291,642, issued to Pageaud et al., teaches a method of producing at least one non-metallized strip on metallized flexible plastic film rolls and a method of producing stacked or wound capacitors using such rolls. One feature of the process of producing at least one non-metallized strip is that the said non-metallized strip is produced by a laser beam applied to the lateral face of a roll at a non-zero angle of incidence α.

Okuno et al., in U.S. Pat. No. 5,905,628, disclose a metallized film capacitor formed by laminating or winding a metallized film with metal evaporated electrode on one or both sides thereof so that a pair of metal evaporated electrodes are opposite to each other, wherein electrode lead-out portions are provided at both ends of the capacitor, each metal evaporated electrode is composed of a low resistance area abutting on the electrode lead-out portion and a remaining high resistance area having higher resistance than it, a split electrode pattern with a plurality of minute blocks formed in a longitudinal direction and width direction and fusing areas between the adjacent minute blocks is formed on at least one of the metal evaporated electrodes, and electrode partitioning lines are formed at regular intervals in a longitudinal direction of the film. The metallized film is fabricated by depositing a substance such as oil for preventing evaporation of metal on the evaporation side of a plastic film through a rotary screen cylinder with any pattern formed by mesh processing and immediately thereafter depositing evaporated metal, thereby forming a split fuse pattern serving as a safeguard mechanism during high speed evaporation.

U.S. Pat. No. 5,942,283, issued to Okuno et al., provides a metallized film capacitor formed from a pair of metallized films. Each of the metallized films includes a dielectric film with a metal evaporated electrode formed thereon. One electrode has longitudinal electrode partitioning lines and a plurality of small blocks separated by fuse areas, while the other electrode does not. Each metallized film is formed by moving the film over a screen cylinder having a side wall with openings formed therein. A nozzle is disposed inside the screen cylinder, adjacent to the side wall. Oil is ejected from the nozzle, while the screen cylinder is rotated. The oil passes through the side wall and is deposited on the film to form a pattern thereon. Subsequently, evaporated metal is deposited on the film.

Cahalen et al., in U.S. Pat. No. 7,190,016, describe structures including a capacitor dielectric material disposed on the surface of an electrode suitable for use in forming capacitors are disclosed. Methods of forming such structures are also disclosed by Cahalen et al.

U.S. Pat. No. 7,495,887, issued to Cox provides a polymeric dielectric composition having a paraelectric filler with a dielectric constant between 50 and 150. Such compositions are said to be well suited for electronic circuitry, such as, multilayer printed circuits, flexible circuits, semiconductor packaging and buried film capacitors.

Rzeznik, in U.S. Published Patent Application No. 2006/ 0022304, discloses dielectric structures which are said to be particularly suitable for use in capacitors having a layer of a dielectric material including a dopant that provides a positive topography. Methods of forming such dielectric structures are also disclosed. Such dielectric structures are said to show increased adhesion of subsequently applied conductive layers.

There continues to be a need in the art for new methods of producing highly conductive electrodes that are suitable for stretchable thin film polymer devices. These electrodes should optionally be patterned or textured.

### SUMMARY OF THE INVENTION

Accordingly, the present invention provides a method of producing a metallized polymer-electrode composite comprising transferring a conductive metal foil from a metal transfer film to a surface of a polymer film. The inventive method may be used to produce a polymer film with textured, conductive metal electrodes on one or both sides. The method of the invention may find utility in producing electroactive polymer transducers and in other thin film devices requiring flexibility or stretchability such as thin film batteries, sensors, speakers, reflective plastic displays, solar cells, and supercapacitors.

These and other advantages and benefits of the present invention will be apparent from the Detailed Description of the Invention herein below.

### BRIEF DESCRIPTION OF THE FIGURES

The present invention will now be described for purposes of illustration and not limitation in conjunction with the figures, wherein:
Figure 1 is a block diagram of a cold foil stack;
Figure 2A is a block diagram illustrating the layer composition of a hot stamp foil stack having one release layer; and
Figure 2B is a block diagram showing the layer composition of a hot stamp foil stack having two release layers.

### DETAILED DESCRIPTION OF THE INVENTION

The present invention will now be described for purposes of illustration and not limitation.

Examples of electroactive polymer devices and their applications are described, for example, in U.S. Pat. Nos. 6,343,129; 6,376,971; 6,543,110; 6,545,384; 6,583,533; 6,586,859; 6,628,040; 6,664,718; 6,707,236; 6,768,246; 6,781,284; 6,806,621; 6,809,462; 6,812,624; 6,876,135; 6,882,086; 6,891,317; 6,911,764; 6,940,221; 7,034,432; 7,049,732; 7,052,594; 7,062,055; 7,064,472; 7,166,953; 7,199,501; 7,199,501; 7,211,937; 7,224,106; 7,233,097; 7,259,503; 7,320,457; 7,362,032; 7,368,862; 7,378,783; 7,394,282; 7,436,099; 7,492,076; 7,521,840; 7,521,847; 7,567,681; 7,595,580; 7,608,989; 7,626,319; 7,750,532; 7,761,981; 7,911,761; 7,915,789; 7,952,261; 8,183,739; 8,222,799; 8,248,750; and in U.S. Patent Application Publication Nos.; 2007/0200457; 2007/0230222; 2011/0128239; and 2012/0126959.

The present inventors have developed a process using commercially available metal foil technology to transfer a conductive metal film onto the dielectric layer that can be done on a batch basis but is particularly useful for roll-to-roll processing.

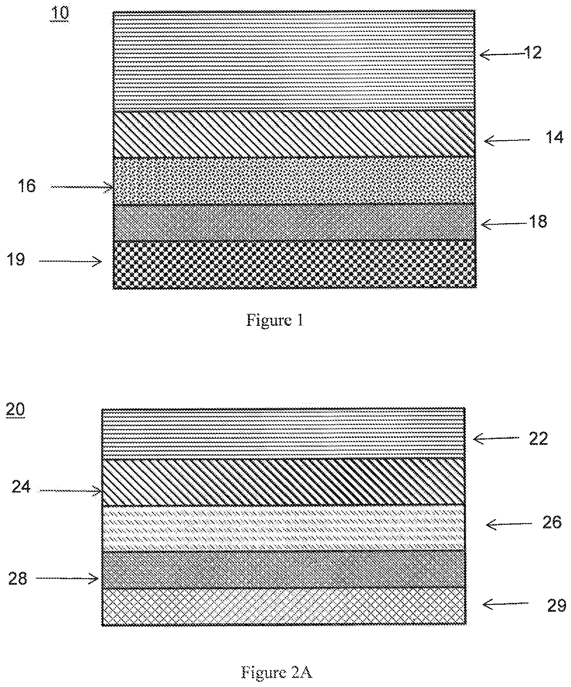

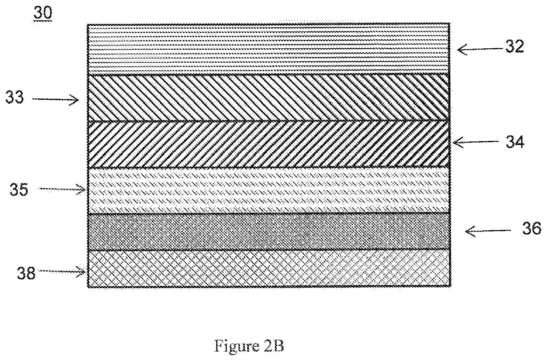

Metal transfer foils are commonly used in the printing industry. Such foils generally have multiple layers of substrate, release layer, primers, and metallization. Examples of such foils are depicted in Figures 1, 2A and 2B. These foils may be supplied with embossed holograms and other textures. A thermoplastic (e.g. polyethylene terephthalate) substrate may be embossed with corrugations and other textures at high speed because it is generally very thin and supplied in large rolls. Similarly, the release layer and primers may be wet- or dry coated at very high speeds using standard coating technologies such as Meyer rod or evaporative coating. The layers may be very thin. Metallization can also be performed at high speeds as the substrates generally used (polyesters) have high density and out-gas relatively little when compared to most plastic films, The entire process may preferably be a roll-to-roll process.

Cold foils are often used to create metallic features in printed media. In the inventive process described herein, an adhesive may preferably be printed in the desired pattern on a dielectric film or on the cold foil, and the cold foil is then laminated onto the dielectric film. A thin metal layer is transferred to the dielectric film in the pattern of the adhesive when the cold foil substrate is removed from the laminated stack to create a dielectric-electrode composite. To create a flexible capacitor or electroactive polymer device, another cold foil may be applied to the opposite surface of the dielectric film or two dielectric-electrode composites may be laminated together.

A cold foil stack **10** is shown as a block diagram in Figure 1. As can be appreciated by reference to Figure 1, a thermoplastic (e.g. polyethylene terephthalate) base layer **12** has a release layer **14** placed thereon. The release layer has a primer layer **16** placed on it and a conductive metal layer **18** is adjacent to the primer layer. Conductive metals suitable in the metal layer include, but are not limited to, silver, copper, gold, aluminum, zinc, nickel, brass, tin, bronze, iron and platinum. Silver, aluminum and tin are particularly suitable in the present invention. The metal layer **18** is overlaid with a second primer layer **19.**

Features printed onto the cold foil may have higher resolution and better dimensional control due to the greater mechanical stability of the metal transfer foil substrate over that of the dielectric film which is generally a soft elastomer, preferably having a Young's modulus of less than 100 MPa. The cold foil mechanical stability may also enable considerably faster print speeds than one can obtain on soft dielectric films.

Hot stamping foils are similar to cold foils and may also be used in the inventive process in an analogous fashion, but the transfer process may require additional thermal and pressure treatments to activate the adhesive layers. Metal transfer foils made from other materials with a similar stack structure may also be used. It may be possible to eliminate primer layers or to include adhesive layers. The primer and/or adhesive layers may also be patterned before use. The adhesives may be B-staged, hot-melt or pressure sensitive. It may also be advantageous to use more compliant or conductive materials such as silver to improve performance. The texture may also be varied to optimize stretchability of the composite structure while maintaining conductivity.

Hot stamping foils are illustrated by the block diagrams in Figures 2A and 2B. Figure 2A provides an example of a hot stamping foil **20** having one release layer **24** on carrier film **22.** The release layer has a coloring and protective layer **26** arranged upon it with a metallized layer **28** adjacent to the protective layer **26**. The metallized layer is covered with a sizing layer **29**.

Figure 2B provides a block diagram of a hot stamping foil **30** having a first **33** and second **34** release layer on a carrier layer **32.** The second release layer **34** is separated from the metallized layer **36** by a coloring and protective layer **35.** Metallized layer **36** may have a sizing layer **38** covering it. The metallized layer **36** may also have an optional corrosion protection layer (not shown) between it and the sizing layer **38.**

The inventive process may also have the advantage of fault-tolerance where the thin metal electrode is able to ablate away around flaws and defects that lead to localized heating or dielectric failure. As is known in the art, this can disconnect electrical connections to the flawed area to electrically isolate the defect and enable continued operation.

In one embodiment of the inventive process, a dielectric film may be cast or coated directly onto the metallized side of the cold foil to metallize the bottom side of the dielectric film. The process of the present invention may further comprise laminating on an interleaf material after the dielectric film has been cured or dried. The metal layer adheres to the dielectric film and the two layers can be removed together from the cold foil substrate. The cold foil may have a pattern to the primer layer or have a patterned adhesive applied to make patterned electrodes. The metal may also be removed by known patterning methods such as selective etching or photolithography. Two layers of metallized dielectric film may be wet or dry laminated together to fabricate an electroactive polymer device, A dielectric or conductive adhesive or separate layer may be laminated between these layers to make a multi-layer stack.

Alternatively, the process of the present invention may be used to cast /coat the dielectric film onto a standard release liner, cure/dry as usual, and laminate the cold foil onto the top surface of the film. The dielectric film may preferably have high tack like a pressure-sensitive adhesive to facilitate transfer of the metal layer to the dielectric film from the cold foil substrate. Alternatively, an adhesive may be applied before lamination which would also enable patterning of the metal that is transferred using an appropriate method to print the adhesive.

The inventive method may include a combination of the above steps: cast onto the cold foil and laminate on another layer of cold foil after the dielectric film has at least partially cured/dried. This embodiment has the advantage of avoiding the use of additional consumables such as release liners and interleaves.

In all cases, care should be taken to avoid cracking the metal film through operations such as stretching the dielectric film when removing the cold foil substrate or making through-hole ("via") connections. Also, removing the release layer or primer on the surface of the transferred metal film may facilitate the use of surface electrical connections, perhaps using electrically conductive adhesive.

Although the intended application for the inventive method is for use in electroactive polymer transducers, the present inventors speculate that it may find utility in other thin film devices requiring flexibility and/or stretchability such as thin film batteries, sensors, speakers, reflective plastic displays, solar cells, and supercapacitors.

### EXAMPLES

The present invention is further illustrated, but is not to be limited, by the following examples.

A proprietary, two-part, addition-cured silicone elastomer formulation used as the dielectric elastomer for electroactive polymer transducers was cast onto a holographic foil film from API (Santa Fe Springs, CA, USA). It was cured at 150°C for three minutes.

After cure, the dielectric film was removed from the foil substrate and the metallization was cleanly transferred to the surface of the dielectric film. Using razor blade contacts to break through the release layer/primer on the surface of the metallization, a conductance of about 2e⁻⁴ siemens was measured. The sheet conductivity of the metallized layer was expected to be higher. The film itself before transfer had a surface conductivity of about 3e⁻² siemens/sq - but microcracks were observed around the contact points and it is believed that these added a significant interconnection resistance to the measurement.

Similarly, the metallization was successfully laminated to both acrylate and silicone pressure sensitive adhesive materials. A double cast layer of silicone and silicone pressure sensitive adhesive was also successful.

A triple layer sample was made with a holographic cold foil film from K Laser (Garden Grove, CA, USA) by sequentially casting and curing silicone pressure sensitive adhesive, silicone elastomer, and silicone pressure sensitive adhesive onto the foil followed by lamination of another sheet of foil. After removal of the release liner, a conductance of 0.05 siemens was measured.

The foregoing examples of the present invention are offered for the purpose of illustration and not limitation. The scope of the invention is to be measured by the appended claims.

## Claims

1. A method of producing a metalicised polymer-electrode composite comprising transferring a conductive metal foil (18,28,36) from a metal transfer film (10,20,30) to a surface of a polymer film, wherein the conductive metal foil (18,28,36) has a texture or a corrugation capable of being stretched without loss of conductivity, wherein the step of transferring comprises:
casting a curable polymer film-forming formulation onto a surface of a conductive metal transfer film (10,20,30) having conductive metal foil (18,28,36) thereon;
curing the formulation to form a polymer film having a first surface in contact with the surface of the conductive metal transfer film (10,20,30) having conductive metal foil (18,28,36) thereon; and
removing the cured polymer film from the conductive metal transfer film (10,20,30), thereby transferring metal foil (18,28,36) to the first surface of the polymer film.

2. The method according to Claim 1 further comprising laminating two polymer-electrode composites to form an electrode-polymer-electrode composite.

3. The method according to Claim 1 further comprising providing a second electrode to the opposite side of the polymer film to form an electrode-polymer-electrode composite.

4. The method according to Claim 3, wherein the second electrode comprises a second metal foil transferred from a second conductive metal transfer film.

5. The method according to any one of Claims 1 to 4, wherein the steps of casting, curing and removing are repeated to form a multilayer polymer electrode composite.

6. The method according to any one of Claims 1 to 5, wherein the conductive metal transfer film further comprises a patterned transfer layer.

7. The method according to Claim 6, wherein the patterned transfer layer is selected from a group consisting of a patterned adhesive and a patterned primer layer.

8. The method according to any one of Claims 1 to 7, wherein the polymer is selected from the group consisting of silicone, acrylate and polyurethane.

9. The method according to any one of Claims 1 to 8, wherein the polymer comprises a pressure sensitive adhesive.

10. The method according to any one of Claims 1 to 9, wherein the metal transfer film is selected from the group consisting of cold foil and hot stamp foil.

11. An electroactive polymer transducer including the metalized polymer-electrode composite made according to any one of Claims 1 to 10.

## Patentansprüche

1. Ein Verfahren zum Herstellen eines metallisierten Polymer-Elektrode-Verbundstoffs, beinhaltend das Übertragen einer leitfähigen Metallfolie (18, 28, 36) von einem Metallübertragungsfilm (10, 20, 30) auf eine Oberfläche eines Polymerfilms, wobei die leitfähige Metallfolie (18, 28, 36) eine Textur oder eine Wellung aufweist, die ohne Leitfähigkeitsverlust gedehnt werden kann, wobei der Schritt des Übertragens Folgendes beinhaltet:
Gießen einer aushärtbaren Polymerfilm bildenden Formulierung auf eine Oberfläche eines leitfähigen Metallübertragungsfilms (10, 20, 30) mit einer leitfähigen Metallfolie (18, 28, 36) darauf;
Aushärten der Formulierung, um einen Polymerfilm mit einer ersten Oberfläche, die mit der Oberfläche des leitfähigen Metallübertragungsfilms (10, 20, 30) in Kontakt steht, mit leitfähiger Metallfolie (18, 28, 36) darauf zu bilden; und
Entfernen des ausgehärteten Polymerfilms von dem leitfähigen Metallübertragungsfilm (10, 20, 30), wodurch Metallfolie (18, 28, 36) auf die erste Oberfläche des Polymerfilms übertragen wird.

2. Verfahren gemäß Anspruch 1, das ferner das Laminieren von zwei Polymer-Elektrode-Verbundstoffen beinhaltet, um einen Elektrode-Polymer-Elektrode-Verbundstoff zu bilden.

3. Verfahren gemäß Anspruch 1, das ferner das Bereitstellen einer zweiten Elektrode an die gegenüberliegende Seite des Polymerfilms beinhaltet, um einen Elektrode-Polymer-Elektrode-Verbundstoff zu bilden.

4. Verfahren gemäß Anspruch 3, wobei die zweite Elektrode eine zweite Metallfolie, übertragen von einem zweiten leitfähigen Metallübertragungsfilm, beinhaltet.

5. Verfahren gemäß einem der Ansprüche 1 bis 4, wobei die Schritte des Gießens, Aushärtens und Entfernens wiederholt werden, um einen mehrschichtigen Polymer-Elektrode-Verbundstoff zu bilden.

6. Verfahren gemäß einem der Ansprüche 1 bis 5, wobei der leitfähige Metallübertragungsfilm ferner eine gemusterte Übertragungsschicht beinhaltet.

7. Verfahren gemäß Anspruch 6, wobei die gemusterte Übertragungsschicht aus einer Gruppe ausgewählt ist, die aus einem gemusterten Klebemittel und einer gemusterten Primerschicht besteht.

8. Verfahren gemäß einem der Ansprüche 1 bis 7, wobei das Polymer aus der Gruppe ausgewählt ist, die aus Silikon, Acrylat und Polyurethan besteht.

9. Verfahren gemäß einem der Ansprüche 1 bis 8, wobei das Polymer ein druckempfindliches Klebemittel beinhaltet.

10. Verfahren gemäß einem der Ansprüche 1 bis 9, wobei der Metallübertragungsfilm aus der Gruppe ausgewählt ist, die aus Kaltfolie und Heißprägefolie besteht.

11. Ein elektroaktiver Polymerwandler, der den metallisierten Polymer-Elektrode-Verbundstoff, gefertigt gemäß einem der Ansprüche 1 bis 10, umfasst.

## Revendications

1. Une méthode de production d'un composite polymère-électrode métallisé comprenant le transfert d'une feuille métallique conductrice (18, 28, 36) d'un film de transfert de métal (10, 20, 30) sur une surface d'un film polymère, la feuille métallique conductrice (18, 28, 36) ayant une texture ou une ondulation capable d'être étirée sans perte de conductivité, l'étape consistant à transférer comprenant :
le fait de faire couler une formulation filmogène de polymère durcissable sur une surface d'un film de transfert de métal conducteur (10, 20, 30) ayant une feuille métallique conductrice (18, 28, 36) sur celui-ci ;
le fait de faire durcir la formulation pour former un film polymère ayant une première surface en contact avec la surface du film de transfert de métal conducteur (10, 20, 30) ayant une feuille métallique conductrice (18, 28, 36) sur celui-ci ; et
le fait de retirer le film polymère durci du film de transfert de métal conducteur (10, 20, 30), transférant de ce fait la feuille métallique (18, 28, 36) sur la première surface du film polymère.

2. La méthode selon la revendication 1 comprenant en outre le fait de stratifier deux composites polymère-électrode pour former un composite électrode-polymère-électrode.

3. La méthode selon la revendication 1 comprenant en outre le fait de fournir une deuxième électrode sur le côté opposé du film polymère pour former un composite électrode-polymère-électrode.

4. La méthode selon la revendication 3, dans laquelle la deuxième électrode comprend une deuxième feuille métallique transférée depuis un deuxième film de transfert de métal conducteur.

5. La méthode selon n'importe laquelle des revendications 1 à 4, dans laquelle les étapes consistant à couler, durcir et retirer sont répétées pour former un composite polymère électrode multicouche.

6. La méthode selon n'importe laquelle des revendications 1 à 5, dans laquelle le film de transfert de métal conducteur comprend en outre une couche de transfert à motif.

7. La méthode selon la revendication 6, dans laquelle la couche de transfert à motif est sélectionnée dans un groupe constitué d'un adhésif à motif et d'une couche d'apprêt à motif.

8. La méthode selon n'importe laquelle des revendications 1 à 7, dans laquelle le polymère est sélectionné dans le groupe constitué de silicone, d'acrylate et de polyuréthane.

9. La méthode selon n'importe laquelle des revendications 1 à 8, dans laquelle le polymère comprend un adhésif sensible à la pression.

10. La méthode selon n'importe laquelle des revendications 1 à 9, dans laquelle le film de transfert de métal est sélectionné dans le groupe constitué d'une feuille froide ou d'une feuille pour estampage à chaud.

11. Un transducteur de polymère électroactif incluant le composite polymère-électrode métallisé fabriqué selon n'importe laquelle des revendications 1 à 10.
